# EUROPEAN PATENT APPLICATION

(11) **EP 1 783 498 A2**
(43) Date of publication of application: **09.05.2007**
(21) Application number: 06123534.7
(22) Date of filing: 06.11.2006
(51) Int. Cl.: G01P 15/18, G01P 15/08, G01P 1/02

(54) **Sensor block**

(30) Priority: 07.11.2005 JP 2005322565
(71) Applicant: MITUTOYO CORPORATION, Kawasaki-shi, Kanagawa-ken 213-0012 (JP)
(72) Inventor: Matsumiya, Sadayuki, Kanagawa 213-0012 (JP); Tominaga, Atsushi, Kanagawa 213-0012 (JP)
(74) Representative: Skone James, Robert Edmund

(57) **Abstract**

The present invention provides a sensor block, which comprises a plurality of sensor chips in combination. Each sensor chip includes a semiconductor substrate having a detection unit formed therein, and two glass substrates bonded to both sides of the semiconductor substrate. One of the glass substrates is shared among the sensor chips and serves as a base block to support the sensor chips.

## Description

The present invention relates to a sensor block equipped with sensor chips (such as acceleration sensor chips, force sensor chips, temperature sensor chips, and biosensor chips).

### Description of the Related Art

A conventional one-axis sensor chip of a triple-layered structure may include a semiconductor substrate having a detection unit formed therein, and glass substrates bonded to both sides thereof. Such one-axis sensor chips are attached to a base block, or a reference block, using an adhesive or the like to form a widely used sensor block.

JP 2001-183389 discloses a sensor block, which includes a sensor chip bonded to a glass substrate, or a reference block, by anodic bonding with the use of no adhesive. This is effective to improve the accuracy that becomes worse due to a difference in thermal expansion coefficient between an adhesive and an element adhered thereto and to reduce thermal stresses exerted at the time of bonding and deformations of elements to be bonded.

The sensor block thus configured, however, results in a larger size of the whole sensor and requires much expense in time and effort on works of adhering the sensor chip. A sensor block including a plurality of sensor chips suffers a reduction in reliability due to a difference in thermal expansion coefficient between elements or the like and a reduction in measurement accuracy due to accumulation of geometric errors.

The present invention is directed to a sensor block, which comprises a plurality of sensor chips in combination. Each sensor chip includes a semiconductor substrate having a detection unit formed therein, and two glass substrates bonded to both sides of the semiconductor substrate. One of the glass substrates is shared among the sensor chips and serves as a base block to support the sensor chips.
Fig. 1 is a perspective view showing a mounting structure of a sensor according to an embodiment of the present invention.
Fig. 2 is an exploded perspective view of Fig. 1.
Fig. 3 is a perspective view showing a mounting structure of a sensor according to another embodiment of the present invention.
Fig. 4 is a perspective view showing a mounting structure of yet another sensor.

Embodiments of the present invention will now be described below with reference to the accompanying drawings.

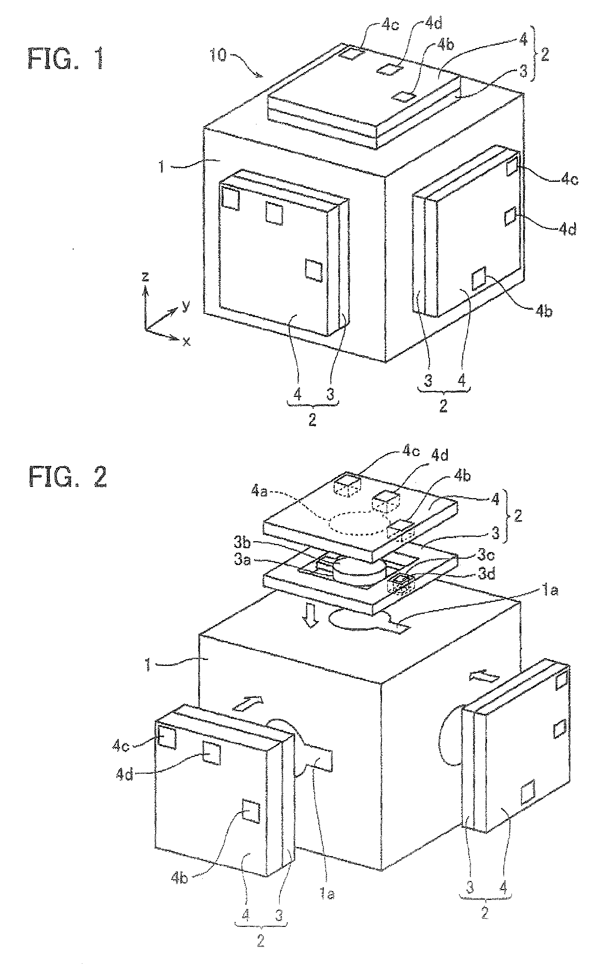

Fig. 1 is a perspective view of a sensor according to an embodiment of the present invention, and Fig. 2 is an exploded perspective view thereof.

A sensor block 10 comprises a base block 1, which includes a glass substrate having electrodes 1a multi-face patterned thereon. Sensor chips 2, or capacitive acceleration sensors operative to measure accelerations in this example, are mounted on X, Y and Z faces of the base block 1, respectively. The sensor chip 2 includes a semiconductor substrate 3 having a weight 3a displaceable in response to the acceleration and an electrode 3b; and a glass substrate 4 having a surface opposite to the semiconductor substrate 3, on which an electrode 4a is disposed to detect the relative displacement of the weight 3a. The semiconductor substrate 3 is bonded to the glass substrate 4 by anodic bonding, The semiconductor substrate 3 is provided with a contact hole 3d, which is surrounded by an insulator 3c. The glass substrate 4 is provided with contact holes 4b-d. The electrode 1a can be electrically bonded to an external component through the contact holes 3d and 4b filled with a electroconductive material such as a electroconductive resin. Similarly, the electrode 3a through the contact hole 4c, and the electrode 4a through the contact hole 4d. The electrodes 1a and 4b can be formed on the base block 1 and the glass substrate 4 using photolithography though a process of electroconductive ink printing or direct drawing may be employed to much easily implement the step of multi-face patterning.

The following description is given to the effect of the sensor thus configured.

Bonding surfaces on one side of the sensor chips 2 commonly to a single base block makes it possible to omit the glass substrate that has been interposed between the semiconductor substrate 3 and the base block 1 conventionally. This is effective to achieve a downsized sensor block and reduce the number of assembly steps. A reduction in elements of the glass substrate can relieve the measurement accuracy from becoming worse due to geometrical errors on combination of elements and can improve the measurement accuracy. An increase in the number of natural frequencies resulted from the downsized sensor can realize a faster response speed of the sensor block and achieve a reduced measurement time.

This example uses anodic bonding as means to bond the base block 1 to the semiconductor substrate 3. Alternatively, the base block 1 may be glass-glass bonded to the semiconductor substrate 3 through low melting glass such as flit glass interposed therebetween. Otherwise, Si-Si eutectic bonding through a thin film of Au-Ge or Au-Sn, or Si-Si bonding through a layer of SiO₂ may be used to carry out the present invention.

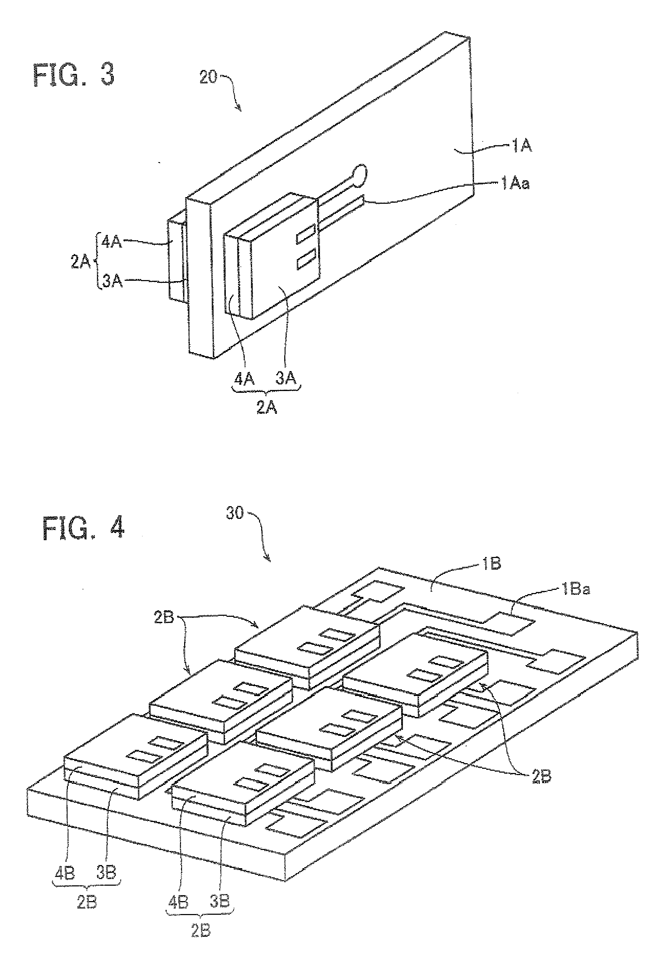

In this embodiment, the sensor chips 2 are placed on X, Y and Z faces of a hexahedron to configure a multi-axis sensor. Alternatively, sensor chips 2A may be arranged on opposite sides of a base block 1A having electrodes 1Aa formed on both sides to configure a double-sided sensor block 20 as shown in Fig. 3. Otherwise, a plurality of sensor chips may be arranged on one side of a glass substrate 1B to configure a compound sensor block 30 as shown in Fig. 4. These configurations also make it possible to carry out the present invention.

In this embodiment, the sensor chips are exemplified as the capacitive acceleration sensor chips. Alternatively, a plurality of any sensor chips capable of detecting different physical quantities may be employed in combination so long as the substrate to be bonded to one side of the semiconductor substrate having the detection unit formed therein can be formed of the same material. For example, they may be acceleration sensor chips, force sensor chips, angular velocity sensor chips, motion sensor chips, temperature sensor chips, pressure sensor chips, optical sensor chips, and biosensor chips. In accordance with the use, the number and kind of sensor chips can be selected arbitrarily to carry out the present invention.

## Claims

1. A sensor block, comprising a plurality of sensor chips each including a semiconductor substrate having a detection unit formed therein,
wherein the semiconductor substrates of said sensor chips are electrically bonded to a common base block and supported thereon.

2. The sensor block according to claim 1, wherein said plurality of sensor chips include any one or more sensor chips of acceleration sensor chips, force sensor chips, angular velocity sensor chips, motion sensor chips, temperature sensor chips, pressure sensor chips, optical sensor chips, and biosensor chips.

3. The sensor block according to any of the preceding claims, wherein said base block is composed of glass and anodic bonded to the semiconductor substrates of said sensor chips.

4. The sensor block according to any of the preceding claims, wherein said base block is glass-glass bonded to said semiconductor substrate through low melting glass.

5. The sensor block according to any of the preceding claims, wherein said base block is bonded to said semiconductor substrate by Si-Si eutectic bonding through a thin film of Au-Ge or Au-Sn.

6. The sensor block according to any of the preceding claims, wherein the base block is Si-Si bonded to said semiconductor substrate through SiO₂.

7. The sensor block according to any of the preceding claims. wherein said base block is a substantially regular hexahedron having at least one face bonded to the semiconductor substrate of said sensor chip.

8. The sensor block according to any of the preceding claims, wherein said base block is in the form of a flat plate having a set of opposite faces each bonded to the semiconductor substrate of said one or more sensor chips.

9. The sensor block according to any of the preceding claims, wherein said base block is in the form of a flat plate having one face bonded to the semiconductor substrates of said plurality of sensor chips.

10. The sensor block according to claim 4, wherein said low melting glass is flit glass.

11. The sensor block according to any of the preceding claims, wherein said base block includes a glass substrate having multi-face patterned electrodes thereon.

12. The sensor block according to claim 11, wherein the electrodes on said base block are formed through a process of photolithography, electroconductive ink printing or direct drawing.

13. The sensor block according to any of the preceding claims, wherein said sensor chip includes an output electrode to feed a detected value to the electrode on said base block, wherein said output electrode is formed through a process of photolithography, electroconductive ink printing or direct drawing.

14. The sensor block according to claim 13. wherein said output electrode is electrically bonded to the electrode on said base block through a contact hole filled with a electroconductive material.

15. The sensor block according to claim 13. wherein said electroconductive material is a electroconductive resin.

16. The sensor block according to any one of claims 1, wherein said semiconductor substrate has a side bonded to said sensor block and an opposite side bonded to a glass substrate.
